# EUROPÄISCHE PATENTSCHRIFT

(11) **EP 3 257 148 B1**
(45) Veröffentlichungstag und Bekanntmachung des Hinweises auf die Patenterteilung: **12.12.2018**
(21) Anmeldenummer: 16715233.9
(22) Anmeldetag: 13.02.2016
(51) Int. Cl.: H02N 1/08, B81B 3/00

(54) **ELEKTROSTATISCHER MIKROGENERATOR UND VERFAHREN ZUR ERZEUGUNG ELEKTRISCHER ENERGIE MITTELS EINES ELEKTROSTATISCHEN MIKROGENERATORS**
ELECTROSTATIC MICROGENERATOR AND METHOD FOR GENERATING ELECTRICAL ENERGY USING AN ELECTROSTATIC MICROGENERATOR
MICROGÉNÉRATEUR ÉLECTROSTATIQUE ET PROCÉDÉ DE GÉNÉRATION D'ÉNERGIE ÉLECTRIQUE AU MOYEN D'UN MICROGÉNÉRATEUR ÉLECTROSTATIQUE

(30) Priorität: 13.02.2015 LU 92654
(43) Veröffentlichungstag der Anmeldung: 20.12.2017
(73) Patentinhaber: Beckmann, Günter, 85221 Dachau (DE)
(72) Erfinder: BISCHUR, Enrico, 80528 München (DE); SCHWESINGER, Norbert, 85386 Eching (DE); ZÄHRINGER, Sandy, 85221 Dachau (DE)
(74) Vertreter: Klemm, Rolf
(86) Internationale Anmeldenummer: PCT/DE2016/100068
(87) Internationale Veröffentlichungsnummer: WO 2016/127981

(56) Entgegenhaltungen:
- DE-A1-102010 016 499
- US-A1- 2004 113 526
- BISCHUR ENRICO ET AL: "Electret properties of PVDF film material: flexible and lightweight energy harvesting device", PROCEEDINGS OF SPIE, S P I E - INTERNATIONAL SOCIETY FOR OPTICAL ENGINEERING, US, Bd. 9057, 10. März 2014 (2014-03-10), Seiten 90571X-90571X, XP060029795, ISSN: 0277-786X, DOI: 10.1117/12.2045089 ISBN: 978-1-62841-799-9

## Beschreibung

### Technisches Gebiet

Die Erfindung bezieht sich auf einen elektrostatischen Mikrogenerator mit zwei polymeren, doppellagig übereinander angeordneten Elektretfolien, sowie einen Taster mit einem solchen elektrostatischen Mikrogenerator sowie dessen Herstellungsverfahren und auf ein Verfahren zur Erzeugung von elektrischer Energie.

### Stand der Technik

Die US 2004/0113526 A1 beschreibt einen elektromechanischen Wandler mit einer mehrere Lagen umfassenden Struktur, die fähig ist, die Dicke zu verändern. In Richtung der Dicke vom Wandlerelement kann sowohl in als aus dem Wandlerelement Luft fließen. Hierfür sind luftdurchlässige Materialien, wie eine permeable Metallschicht als auch eine permeable Materialschicht, eingesetzt. Die Materialschicht ist permanent mit elektrischer Ladung geladen. Aus BISCHUR ENRICO ET AL: "Electret properties of PVDF film material: flexible and lightweight energy harvesting device", PROCEEDINGS OF SPIE, Bd. 9057, 10. März 2014, Seiten 90571X-90571X, ISSN: 0277-786X, DOI: 10.1117/12.2045089, ISBN: 978-1-62841-799-9 ist wiederum ein elektrostatischer Mikrogenerator mit zwei polymeren, doppellagig übereinander angeordneten Elektretfolien mit jeweils einer einseitig darauf angeordneten metallischen Schicht als Elektrode bekannt, wobei die metallischen Schichten jeweils Kondensatorplatten darstellen und eine in der Höhe veränderbare Fluidkammer zwischen den Kondensatorplatten ausgebildet ist. Die Elektretfolien sind locker gewickelt, so dass durch eine Druckbeaufschlagung das Fluid aus der Fluidkammer herausdrückbar ist und eine Spannung durch die Veränderung des Abstands der Kondensatorplatten erzeugt wird. Wird die Druckbeaufschlagung danach zurückgenommen so strömt das Fluid zwischen die Kondensatorplatten zurück wobei sich der Abstand zwischen den Kondensatorplatten wieder aufweitet und erneut Energie gewonnen werden kann.

### Darstellung der Erfindung

Es ist Aufgabe der vorliegenden Erfindung, einen elektrostatischen Mikrogenerator, einen Taster, ein Verfahren zur Herstellung desselben elektrostatischen Mikrogenerators und ein Verfahren zur Erzeugung von elektrischer Energie zu schaffen, die eine stabile Umwandlung von mechanischer in elektrische Energie gewährleisten.

Erfindungsgemäß wird die Aufgabe durch den Gegenstand der Patentansprüche 1, 13, 14 und 15 gelöst. Vorteilhafte Weiterbildungen ergeben sich aus den abhängigen Ansprüchen.

Ein Gedanke der Erfindung ist, ein Fluid, insbesondere Luft, als Isolationsmedium parallel zu einer Solldruckfläche und parallel zu beabstandeten Kondensatorplatten ein- und ausströmen zu lassen, in dem der Abstand zwischen den Kondensatorplatten variiert wird, um elektrische Energie, also eine abgreifbare Spannung, zu erzeugen. Das Fluid kann gasförmig und somit kompressierbar oder flüssig und somit nicht kompressierbar sein. Beide Ausführungsformen haben für den spezifischen Anwendungsfall Vorteile. Der elektrostatische Mikrogenerator weist hierfür zwei doppellagig übereinander angeordnete, polymere Elektretfolien mit einer jeweils einseitig darauf angeordneten metallischen Schicht als Elektrode auf, wobei die metallischen Schichten jeweils Kondensatorplatten und zwischen den Kondensatorplatten mindestens eine in der Höhe veränderbare Fluidkammern ausbilden, wobei ein Fluid in der mindestens einen Fluidkammer als Isolationsmedium dient, die Elektretfolien in einer für das Fluid hermetisch abgedichteten Hülle eingelagert sind und die Elektretfolien flächig, locker gewickelt und in der hermetisch abgedichteten Hülle mit einem definierten Volumen des Fluids angeordnet sind, wobei in der Hülle mindestens ein Ausgleichsraum für das Fluid vorgesehen ist, mittels Druckbeaufschlagung auf eine erste Solldruckfläche, die parallel zu den Kondensatorplatten auf der Hülle außenliegend vorgesehen ist, das Fluid aus der mindestens einen Fluidkammer in mindestens einen Ausgleichsraum der Hülle herausdrückbar ist und eine Spannung durch eine Veränderung des Abstandes der Kondensatorplatten erzeugbar ist, und unter Druckbeaufschlagung auf eine zweite Solldruckfläche das Fluid, insbesondere Luft und insbesondere ausschließlich, im Wesentlichen in senkrechter Richtung zur Richtung der Druckbeaufschlagung aus dem mindestens einen Ausgleichsraum in der Hülle in paralleler Richtung zur Anordnung der Kondensatorplatten in die mindestens eine Fluidkammer zur Aufweitung des Abstandes zwischen diesen wieder einführbar und zurückführbar ist. Aufgrund dieses spezifischen Aufbaus ist ein Wechselspiel zwischen Einführen von dem Fluid aus der mindestens einen Ausgleichskammer in entleerte Fluidkammern und einem Herauspressen des Fluids aus den zwischen den Kondensatorplatten angeordneten Fluidkammern vereinfacht und effizient. Das Innenvolumen der Hülle ist je nach Anwendungsfall bei einem flüssigen Fluid nicht verkleinerbar und dagegen bevorzugt bei einem gasförmigen Fluid verkleinerbar. Möglich wäre auch einen derartigen Druck aufzubauen, so dass ein Phasenwechsel vom gasförmigen Fluid in ein flüssiges Fluid stattfindet.

Da das Fluid in seinem Volumen durch die hermetisch abdichtende Hülle definiert begrenzt ist, ist die Hülle ein hoch wirksames Mittel, um eine darauf aufgewendete und einwirkende Druckkraft zur Transformation in elektrische Energie effizient einzusetzen. Es ist also vorgesehen, an zwei Stellen auf der Hülle eine Druckkraft im Wechsel aufzubringen, um einen Fluss des Fluids in die eine und die entgegengesetzte Richtung zu bewirken. Die Hülle ist hierbei mit lediglich ungefähr der Hälfte des maximal möglich befüllbaren Fluids gefüllt, um für die zweite Hälfte einen Ausgleichsraum zu schaffen.

In einem ersten Zustand ist das Fluid zwischen Kondensatorplatten in Fluidkammern aufgefüllt und die Hülle auf einer gegenüberliegenden Seite entsprechend entleert. Die Hülle wird auf der, insbesondere von der Elektretfolie, gegenüberliegenden Seite aufgeblasen, wenn eine Druckkraft auf die Hülle und den darunterliegenden Elektretfolienwickel einwirkt. Die gewickelte Elektretfolie mit ihren metallischen Elektroden wird somit an den Fluidkammern zusammenpresst. Um den Ursprungszustand mit aufgefüllten Fluidkammern zwischen den Kondensatorplatten wieder herbeizuführen, wird nun der Abschnitt der Hülle mit der zweiten Solldruckfläche mit einem Ausgleichsraum für das Fluid darunterliegend, der je nach Ausführungsform eine oder keine Elektretfolie aufweist, mit einer Druckkraft beaufschlagt, so dass das Fluid, insbesondere die Luft, zwischen die Kondensatorplatten strömt und die Fluidkammern wieder auffüllt.

Unter "Elektretfolie" wird eine Folie verstanden, die dauerhaft elektrostatisch polarisiert ist. Die Elektretfolie hat bevorzugt eine Stärke von 1 µm bis ca. 100 µm, weiter bevorzugt ca. 20 µm bis ca. 50 µm. Somit wird ein stabiler elektrostatischer Mikrogenerator geschaffen mit einer stabilen Umwandlung von mechanischer in elektrische Energie. Der elektrostatische Mikrogenerator ist derart vereinfacht aufgebaut, so dass er kosteneffizient herstellbar ist und eine breite Anwendung möglich ist.

Um den Wirkungsgrad deutlich zu erhöhen, sind im Querschnitt gesehen die Elektretfolien zu mehreren Folienkondensatoren in Serie mit einem veränderbaren Abstand der Kondensatorplatten zu einem Folienwickel flächig gewickelt, wobei jeweils Seiten der Elektretfolie gleicher Polarität zueinander angeordnet und die Kondensatorplatten als Elektroden gleicher Polarität zusammen zu einer Leitung verschaltet sind. Somit wird eine deutlich höhere Spannung erzeugt abhängig von der Anzahl der in Serie geschalteten Folienkondensatoren.

Es hat sich bei einer weiter bevorzugten Ausführungsform als vorteilhaft herausgestellt, dass die auf der Elektretfolie angeordnete metallische Schicht und insbesondere die Elektretfolie im Wesentlichen undurchlässig für das Fluid, insbesondere Luft, ausgebildet ist. Dadurch wird der Wirkungsgrad weiter erhöht, und aufgrund des einfachen Aufbaus ist eine effiziente Fertigung für eine wirtschaftliche Umsetzung besser realisierbar.

Gemäß einer die Erfindung weiterbildenden Ausführungsform, und um das Fertigungsverfahren weiter zu vereinfachen und einen hohen Wirkungsgrad des elektrostatischen Mikrogenerators zu erzeugen, ist die metallische Schicht als separate Metallfolie auf der polymeren Elektretfolie angeordnet. Die Effizienz wird somit nicht beeinträchtigt durch eine Durchlöcherung der Elektretfolie und/oder der metallischen Schicht. Gemäß einer alternativen bevorzugten Ausführungsform ist in einem besonderen Fertigungsverfahren die metallische Schicht auf der polymeren Elektretfolie als Metallisierung ausgebildet.

Gemäß einer weiter besonders bevorzugten Ausführungsform, um einen möglichst hohen Wirkungsgrad zu erzeugen und das Herstellungsverfahren sowie den Aufbau des Mikrogenerators zu vereinfachen, weist die Elektretfolie die metallische Schicht auf der einen Seite der Elektretfolie vollständig überdeckend auf.

Gemäß einer alternativen bevorzugten Ausführungsform weist die Elektretfolie die metallische Schicht im Wesentlichen mittig auf der einen Seite mit parallelen freien Randstreifen ohne metallische Schicht auf. Die freien parallelen Randstreifen dienen weiter bevorzugt für elastische Abstandshalter, die jeweils zwischen zwei Lagen der Elektretfolie jeweils an den zwei freien Randstreifen ohne metallische Schicht angeordnet sind. Somit wird sichergestellt, dass für das Fluid, insbesondere die Luft, ein Raum mit Fluidkammern geschaffen wird, der zusammenpressbar ist und durch Gegendruck des Fluids wieder seinen ursprünglichen Raum mit den maximal großen Fluidkammern einnimmt.

Gemäß einer alternativen Ausführungsform ist die metallische Schicht auf der Elektretfolie einseitig auf parallelen Randstreifen mit einem freien mittigen Streifen ohne metallische Schicht ausgebildet.

Gemäß einer die Erfindung weiterbildenden Ausführungsform sind die doppellagig angeordneten Elektretfolien auf einer Seite in der Hülle angeordnet und der mindestens eine Ausgleichsraum auf einer gegenüberliegenden Seite in der Hülle angeordnet ist. Somit sind einfache Wicklungen von Elektretfolien mit Kondensatorplatten als Elektrode herstellbar.

Gemäß einer alternativen Ausführungsform umfasst der elektrostatische Mikrogenerator doppellagig angeordneten Elektretfolien mit dazwischen angeordneten Fluidkammern als wechselseitig ausgebildeter Ausgleichsraum jeweils über der ersten und zweiten Solldruckfläche. Somit wird ein kompakter Mikrogenerator geschaffen. In beiden Ausführungsformen ist eine die Hülle also als Doppeltasche vorgesehen, die durch die zwei Solldruckflächen geschaffen wird.

Hierfür sind weiter bevorzugt elastische Abstandshalter mittig zwischen zwei Lagen der Elektretfolie auf dem freien mittigen Streifen ohne Metallschicht angeordnet. Diese Ausführungsform ist eine alternative Ausführungsform zur oben beschriebenen Ausführungsform, die sicherstellt, dass aus einem Betriebszustand mit zusammengedrückten Elektrodenplatten wieder ein Ursprungszustand hergestellt wird. Außerdem können wechselseitig, also abwechselnd die in Serie geschalteten Elektroden bezüglich des freien mittigen Streifens zusammengepresst werden, so dass automatisch die gegenüberliegenden Kondensatorplatten durch Einströmen des Fluids aufgeweitet werden. Somit ist eine kontinuierliche Energieerzeugung gewährleistet, wobei die Solldruckflächen auf der Oberfläche der Hülle abwechselnd mit einer Druckkraft zu beaufschlagen sind.

Gemäß einer die Erfindung weiterbildenden Ausführungsform sind somit auf der Oberseite der Hülle zwei Solldruckflächen angeordnet, die abwechselnd betätigbar sind, insbesondere ist eine Mechanik vorgesehen, die abwechselnd beide Solldruckflächen mit einer Druckkraft beaufschlagt ausgehend von der Beaufschlagung einer definierten zentralen Tastdruckfläche.

Weiter bevorzugt weist der elektrostatische Mikrogenerator eine Federmechanik auf, die einem Zusammendrücken auf die mindestens eine Solldruckfläche entgegenwirkt und angenäherte Kondensatorplatten zur elektrischen Energieerzeugung wieder aufweitet. Somit wird sichergestellt, dass der elektrostatische Mikrogenerator immer wieder auf Druckeinwirkung stabil mechanische Energie in elektrische Energie umwandelt und zwar in beide Richtungen einmal bei der Annäherung der Kondensatorplatten und einmal bei der Aufweitung der Kondensatorplatten.

Die Aufgabe wird auch durch einen Taster, mit einem oben beschriebenen elektrostatischen Mikrogenerator dadurch gelöst, wobei der Taster ein gefedert gelagertes Tastenelement und eine Signalsteuerung zur Abgabe eines elektronischen Signals bei Betätigung des Tastelements mit Auslösung einer Druckbeaufschlagung auf die Solldruckfläche des Mikrogenerators aufweist. Ein derartiger Taster hat den Vorteil, dass mechanische Energie stabil in elektrische Energie gewandelt wird, einfach aufgebaut ist und der Taster sowohl stationär als auch mobil einsetzbar ist, vor allem überall dort, wo ein Verkabelungsaufwand unvorteilhaft oder aufwändig oder unerwünscht ist.

In Verbindung mit einem Funkmodul kann somit ein autarker Taster geschaffen werden, der von der begrenzten Energiespeicherfähigkeit einer Batterie unabhängig ist, indem elektrische Signale bei Betätigung des Tasters ausgelöst und weitergegeben werden.

Die Aufgabe wird auch durch ein Verfahren zur Herstellung eines oben beschriebenen elektrostatischen Mikrogenerators mit einer polymeren Elektretfolie dadurch gelöst, dass die Elektretfolie derart gewickelt wird, so dass ein Fluid, insbesondere Luft, im Wesentlichen senkrecht zur Richtung der Druckbeaufschlagung auf eine Solldruckfläche des Mikrogenerators zwischen Lagen der Elektretfolie mit Elektroden als Kondensatorplatten parallel zu diesen heraus- und hineinströmbar ist, und die gewickelte Elektretfolie in einer Hülle mit einem definierten Volumen hermetisch dicht verschlossen wird. Dabei kann bevorzugt Luft als gasförmiges Fluid oder dielektrische Öle als flüssiges Fluid in der Hülle mit einem definierten Volumen eingeschlossen und durch unterschiedliche Druckbeaufschlagung auf die Hülle kann der Abstand zwischen den Kondensatorplatten der gewickelten polymeren Elektretfolie verändert werden, so dass stabil mechanische in elektrische Energie effizient gewandelt wird.

Die Aufgabe wird auch durch ein Verfahren zur Erzeugung von elektrischer Energie mittels eines oben beschriebenen elektrostatischen Mikrogenerators dadurch gelöst, dass ein Fluid, insbesondere Luft, als Isolationsmedium parallel zu Kondensatorplatten und senkrecht zu einer Druckbeaufschlagung auf eine Solldruckfläche in einen Ausgleichsraum einer Hülle herausgedrückt wird und umgekehrt das Fluid aus dem Vorratsraum der Hülle aus Fluidkammern zwischen Kondensatorplatten zur Aufweitung des Abstandes zwischen diesen parallel zu den Kondensatorplatten in die Fluidkammer eingeführt und zurückgeführt wird. Durch die Konzentration der Strömungsrichtung parallel zu den Kondensatorplatten und senkrecht zur Druckrichtung wird das stabile Umwandlungsverfahren von mechanischer in elektrische Energie geschaffen. Das Verfahren ist einfach aufgebaut und kosteneffizient realisierbar.

### Kurze Beschreibung der Zeichnungen

Die Erfindung wird im Folgenden anhand von Ausführungsbeispielen unter Bezugnahme auf Zeichnungen näher erläutert. Es zeigen:
Fig. 1a einen locker gewickelten Aufbau eines elektrostatischen Mikrogenerators ohne Hülle;
Fig. 1b den gewickelten elektrostatischen Mikrogenerator gemäß Fig. 1 mit einwirkender Druckkraft;
Fig. 2 eine schematische Anordnung der Elektretfolien mit metallischer Schicht sowie deren Leitungsverschaltung;
Fig. 3a eine schematische erste Ausführungsform des elektrostatischen Mikrogenerators im entspannten Zustand;
Fig. 3b den schematisch dargestellten Mikrogenerator gemäß Fig. 3a mit einwirkender Druckkraft;
Fig. 4a eine zweite Ausführungsform des elektrostatischen Mikrogenerators im entspannten Ausgangszustand;
Fig. 4b die zweite Ausführungsform des Mikrogenerators gemäß Fig. 4a mit einwirkender Druckkraft auf eine Solldruckfläche;
Fig. 5 eine dritte Ausführungsform in schematischer Seitenansicht vom elektrostatischen Mikrogenerator;
Fig. 5a eine schematische Ansicht der dritten Ausführungsform gemäß Fig. 5 mit einer einwirkenden Druckkraft im Querschnitt gesehen linksseitig;
Fig. 5b einen schematischen Querschnitt der dritten Ausführungsform gemäß Fig. 5 mit rechtsseitig einwirkender Druckkraft,
Fig. 6 eine vierte Ausführungsform des elektrostatischen Mikrogenerators;
Fig. 6a eine Querschnittsansicht schematisch mit linksseitig einwirkender Druckkraft der Ausführungsform gemäß Fig. 6;
Fig. 6b eine schematische Ansicht einer Ausführungsform gemäß Fig. 6 mit rechtsseitig einwirkender Druckkraft;
Fig. 7 eine schematische Ansicht eines erfindungsgemäßen Tasters;
Fig. 8 den Verfahrensablauf eines erfindungsgemäßen Herstellungsverfahrens eines elektrostatischen Mikrogenerators; und
Fig. 9 Verfahrensschritte mittels eines Flussdiagramms zur Erzeugung elektrischer Energie mittels eines Mikrogenerators.

### Bester Weg zur Ausführung der Erfindung

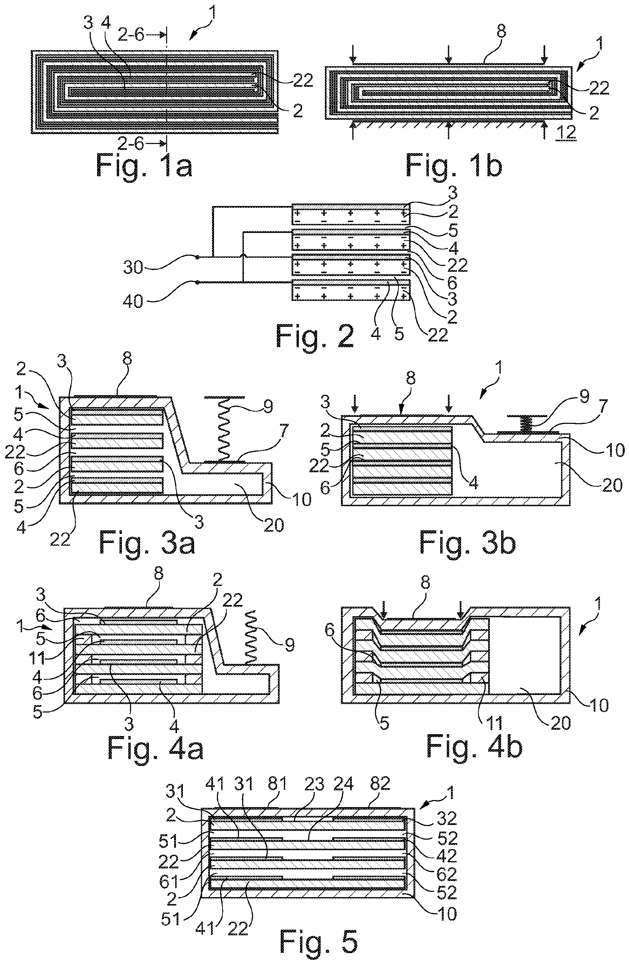

Die Fig. 1 zeigt schematisch einen erfindungsgemäßen elektrostatischen Mikrogenerator 1 mit zwei doppellagig angeordneten, polymeren Elektretfolien 2, 22. Eine Elektretfolie ist definiert als eine dauerhaft elektrostatisch aufgeladene Folie. Einseitig ist eine metallische Schicht als Elektrode auf der Elektretfolie 2, 22 angeordnet. Die Elektretfolien 2, 22 bilden in Doppellage mit zwei metallischen Elektroden Kondensatorplatten 3, 4 zu wenigstens einen Folienkondensator aus. Bevorzugt sind wie in der Fig. 1a gezeigt die doppellagig angeordneten, polymeren Elektretfolien 2, 22 mehrfach flächig zu einem Folienwickel locker gewickelt. Die Fig. 1a zeigt eine dreifache Wicklung. Es versteht sich, dass die Wicklung mehr oder weniger als dreifach gewickelt sein kann. Es ergeben sich bei Mehrfachwicklungen somit mehrere in Serie übereinander angeordnete Folienkondensatoren. In dem Mikrogenerator 1 ist zwischen den einzelnen polymeren Elektretfolien 2, 22 ein Fluid, bevorzugt Luft, als Isolationsmedium, in Fluidkammern 5, 6 eingeschlossen. Die Fluidkammer 5, 6 werden durch Kondensatorplatten 3, 4 sowie den Oberflächenseiten der Elektretfolien 2, 22 ohne metallische Schicht gebildet. Es ist ein veränderbarer Abstand der Kondensatorplatten 3, 4 erzeugbar, wenn eine äußere Druckkraft wie in der Fig. 1b gezeigt auf den Mikrogenerator 1 einwirkt. Bevorzugt ist jeweils die metallische Schicht direkt auf der Elektretfolie 2, 22 ohne Zwischenspalt einseitig angeordnet, so dass kein Spalt zwischen Metallschicht, die entweder als separate Metallfolie ausgebildet ist oder als auf der polymeren Elektretfolie 2, 22 angeordneten Metallisierung ausgebildet ist, und der polymeren Elektretfolie 2, 22 vorliegt. Somit ist jede Elektretfolie 2, 22 ein Träger einer Kondensatorplatte 3, 4.

Die Fig. 1b zeigt die gleiche schematische Querschnittsansicht wie die Fig. 1a, mit dem Unterschied, dass flächig auf eine Solldruckfläche 8 von einer Seite gegen eine Lagerfläche 12 der elektrostatische Mikrogenerator 1 aus der Fig. 1a mit Druck beaufschlagt wird, so dass das eingelagerte Fluid zwischen den doppelten Lagen der polymeren Elektretfolie 2, 22 aus den Fluidkammern 5, 6 herausgedrückt ist. Sowohl im ausdrückenden Prozess als auch im Prozess, der das Fluid wieder zwischen die Kondensatorplatten 3, 4 in die Fluidkammer 5, 6 einführt, wird eine abgreifbare Spannung mit einer effektiven Stromstärke erzeugt, die insbesondere nach Gleichrichtung als elektrisches Signal erfassbar ist und einem elektrischen Verbraucher zuführbar ist.

Die Fig. 2 - 6 bzw. 3b - 6b zeigen schematische Schnittansichten der Fig. 1a, 1b mit einer hermetisch abgedichteten Hülle 10.

Die Fig. 2 zeigt eine schematische vergrößerte Schnittansicht mit zwei doppellagig übereinander angeordneten Elektretfolien 2, 22 zur Bildung des elektrostatischen Mikrogenerators 1. Die Elektretfolien 2, 22 müssen anfänglich nicht zwingend Ladungen aufweisen. Insbesondere piezoelektrische Elektretfolien können auch ohne Anfangspolarisation eingesetzt werden. In der Figur 2 ist die Elektretfolie 2, 22 beispielhaft mit permanenten Polarisierungen ausgebildet. Bei der obersten, ersten Elektretfolie 2 ist deren Oberschicht positiv mit einer metallischen Schicht als Kondensatorplatte 3 geladen. Die untere Seite der Elektretfolie 2 weist eine negative Aufladung ohne metallische Schicht auf. Im entspannten Zustand dem Kondensatoraufbau senkrecht zur Kondensatorplatte 3 folgend ist eine Fluidkammer 5 mit veränderbarer Höhe für das Fluid, hier bevorzugt Luft, vorgesehen Die Höhe der Fluidkammer 5, 6 ist als minimale Höhe zwischen einem direktem Kontakt der Unterseite von der Elektretfolie 2 mit der zweiten Kondensatorplatte 4 und als maximale Höhe mit einem definierten Abstand von der Unterseite der Elektretfolie 2 und der Kondensatorplatte 4 veränderbar. Im Aufbau senkrecht zu dem Kondensator ist die metallische Schicht der Kondensatorplatte 4 mit negativer Polarisierung aufgeladen und mit der zweiten Elektretfolie 22 verbunden. Bei der zweiten Elektretfolie 22 ist umgekehrt die Oberseite negativ und die Unterseite positiv geladen. Es folgt im Aufbau eine weitere Fluidkammer 6 mit veränderbarer Höhe und wiederum der gleichen wie zuvor beschriebenen Anordnung einer ersten Elektretfolie 2 mit einer ersten positiv geladenen Elektrode als Kondensatorplatte 3 und nach einer weiteren Fluidkammer 5, und darauf eine weitere zweite Elektretfolie 22 mit negativ aufgeladener zweiter Elektrode als Kondensatorplatte 4. Wie in der Fig. 2 gezeigt, sind jeweils die Seiten der Elektretfolie 2, 22 gleicher Polarität zueinander angeordnet und die Kondensatorplatten gleicher Polarität zusammen zu einer Leitung verschaltet. Die beiden Kondensatorplatten 4 sind also miteinander zu einer Leitung 40 mit negativer Polarisierung verschaltet sowie die beiden positiv geladenen Kondensatorplatten 3, die die erste Elektrode ausbilden, sind zur positiven Leitung 30 mit positiver Polarisierung verschaltet.

Die Fig. 3a zeigt eine schematische Querschnittansicht des elektrostatischen Mikrogenerators 1 in einer bevorzugten Ausführungsform eingebracht in eine hermetisch abgedichtete Hülle 10, die ein definiertes Fluidvolumen, hier insbesondere ein Fluidvolumen, in einem entspannten Zustand aufweist. Im Querschnitt gesehen ist der Folienwickel mit Elektretfolien 2, 22 linksseitig angeordnet, wohingegen auf der rechten Seite die Hülle 10 bis zu einem definierten Minimum verkleinert ist. Ein wesentliches Merkmal des erfindungsgemäßen Mikrogenerators 1 ist somit eine "Doppeltasche" mit den Elektroden 3, 4 und den Elektretfolien (2, 22) als Dielektrikum und der Hülle 10 ausgebildet, die in einem fiktiv mit Fluid ausgefüllten Zustand ein doppelt so großes Fluidvolumen aufweisen würde, wie erfindungsgemäß eingesetzt. Dadurch dass nur eine Hälfte das tatsächlich möglichen Fluidvolumens sich in der hermetisch abgedichteten Hülle 10 befindet, muss bei Druckbeaufschlagung das Fluid aus dem mit Fluid gefüllten Bereich in einen ungefüllten Ausgleichsraum ausweichen. Über den zwei doppellagig gewickelten Elektretfolien 2, 22 ist auf der Hülle 10 dafür eine Solldruckfläche 8 angeordnet. Gegenüberliegend im Querschnitt gesehen rechts in der Fig. 3a dargestellt ist eine entspannte Feder 9 angeordnet, die auf eine Gegendruckfläche 7 von der Hülle 20 drückt. Die Feder 9 dient als Mechanik, die der Solldruckfläche 8 entgegenwirkt.

Die Fig. 3b zeigt den elektrostatischen Mikrogenerator 1 in einem Zustand, mit einer maximalen Druckeinwirkung auf die Solldruckfläche 8, so dass die Fluidkammern 5, 6 mit der veränderbaren Höhe zu einem minimalen Raum mit minimaler Höhe mit im Wesentlichen direktem Kontakt zwischen der negativ geladenen Unterseite der Elektretfolie 2 mit der negativ geladenen metallischen Schicht der zweiten Elektretfolie 22 kontaktieren. Das Fluid als Isolationsmedium ist aus dem Folienwickel gedrückt worden und definiert nun einen hermetisch abgedichteten Ausgleichsraum 20 rechtsseitig in der Hülle 10. Während des Vorgangs der Druckbeaufschlagung auf die Solldruckfläche 8 gemäß der Fig. 3a zur Fig. 3b erfolgt aufgrund der Abstandsänderung zwischen den Kondensatorplatten 3,4 eine Kapazitätsänderung. Diese Kapazitätsänderung führt zu der gewünschten auftretenden Spannung und ebenso eine Druckbeaufschlagung auf die Gegendruckfläche 7 in umgekehrter Richtung. Mittels der Feder 9 wird wiederum in die Fluidkammern 5 und 6 die vorhandene Fluid aus dem Ausgleichsraum 20 gepumpt, so dass die Elektretfolien 2, 22 mit den beiden Elektroden 3, 4 zu einem Zustand gemäß der Fig. 3a aufgeweitet werden.

Die Fig. 4a zeigt im Querschnitt gesehen eine zweite besondere Ausführungsform des elektrostatischen Mikrogenerators 1. Bei diesem elektrostatischen Mikrogenerator 1 sind die metallischen Schichten 3, 4 jeweils mittig auf der Elektretfolie 2, 22 angeordnet, wobei an parallelen Randstreifen ohne metallische Schicht stattdessen elastische Abstandshalter 11 bevorzugt aus Kunststoff angeordnet sind. Die Solldruckfläche 8 befindet sich ebenfalls direkt über den metallischen Schichten der Kondensatorplatten 3, 4 und ebenfalls nicht an den parallelen Randstreifen im Gegensatz zur Fig. 3a, 3b. Aufgrund der elastischen Abstandshalter 11 werden die Fluidkammer 5 und 6 vordefiniert, so dass das Fluid, die aus den Fluidkammern 5, 6 durch Einwirkung von Druckkraft auf die Solldruckfläche 8 herausgedrückt worden ist, leichter wieder hineinfindet. Hierfür ist das Fluidvolumen durch die hermetisch abgedichtete Hülle 10 definiert.

Die Fig. 4b zeigt einen elektrostatischen Mikrogenerator 1 im belasteten Zustand mit maximal einwirkenden Druckraft auf die Solldruckfläche 8. Der rechtsseitig in der Fig. 4b angeordnete Ausgleichsraum 20 ist maximal mit dem Fluidvolumen aus den minimal verkleinerten Fluidkammern 5, 6 aufgefüllt. Wie zur Fig. 3a, 3b beschrieben, wird der Ausgleichsraum 20 wiederum durch eine Mechanik oder äquivalente Mechanik entleert und die Fluidkammern 5, 6 mittels des Fluidvolumens wieder vergrößert.

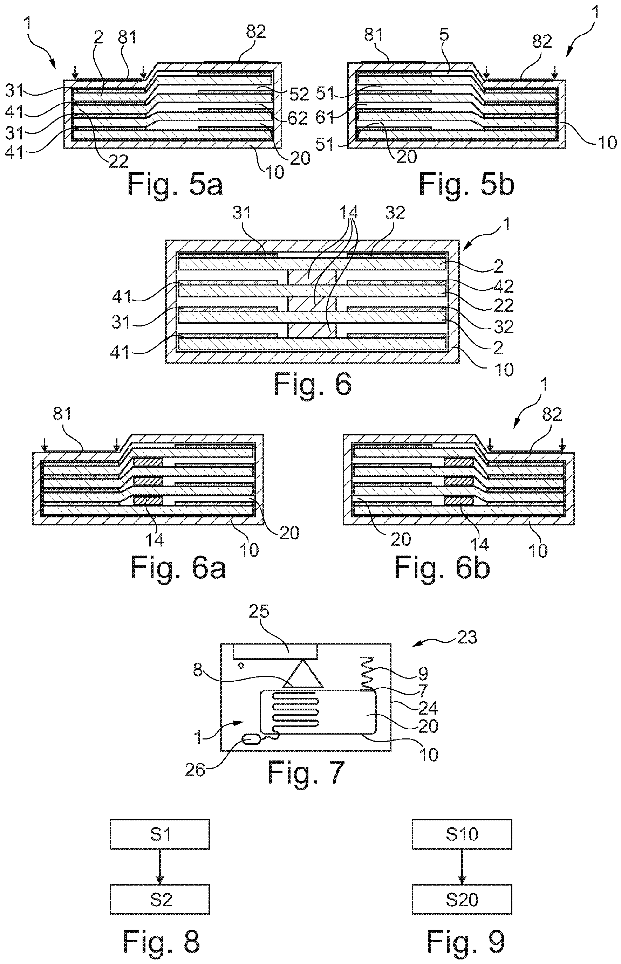

Die Fig. 5, 5a, 5b zeigen eine dritte Ausführungsform des elektrostatischen Mikrogenerators 1. Bei dieser besonderen Ausführungsform sind die metallischen Schichten parallel beidseitig jeweils auf der Oberseite einer Elektretfolie 2, 22 angeordnet, wobei mittig ein freier Streifen 23, 24 ohne metallische Schicht angeordnet ist. Diese Ausführungsform hat zwei Solldruckflächen 81, 82, die jeweils über den metallischen Schichten parallel angeordnet sind. Mittig, wo keine metallischen Schichten angeordnet sind, ist somit auch keine Solldruckfläche vorgesehen.

Die Fig. 5 zeigt den oben beschriebenen Folienwickel im entspannten, unbelasteten Zustand. Alle Fluidkammern 51, 52, 61, 62 weisen zwischen den Kondensatorplatten 3, 4 im Wesentlichen das gleich Fluidvolumen und somit die gleiche Größe und Höhe auf.

Die Fig. 5a zeigt eine linksseitige Druckbelastung der schematischen Querschnittsansicht der Fig. 5, so dass die Fluidkammern 51, 52, 61, 62 aus der Fig. 5 zu einem Minimalvolumen mit minimaler Höhe zusammengedrückt sind und das rechtsseitige Volumen 52, 62 mit Fluid maximal mit mindestens einem Ausgleichsraum 20 aufgefüllt ist. Alle Fluidkammern 51, 61 sind soweit geleert, dass die Elektrode 31 somit die hermetische Hülle 10 von der Innenseite her und die Unterseite der zweiten Elektretfolie 22 berührt und die linksseitige negative Elektrode 41 jeweils die Unterseite der ersten Elektretfolie 2 kontaktiert.

Die Fig. 5b zeigt wie anschließend die Solldruckfläche 82 rechtsseitig maximal mit einer Druckkraft auf die Hülle 10 einwirkt, so dass rechtsseitig und die umgekehrte Richtung auch linksseitig eine maximale Kapazitätsänderung erzeugt wird und Fluid in den Fluidkammern 5, 51, 61 parallel zu den Kondensatorplatten 31, 41 und in senkrechter Richtung zur Druckbeaufschlagung aus den Fluidkammern 52, 62 in die vorher geschlossenen Fluidkammern 51, 61 gedrückt wird und diesen den Ausgleichsraum 20 bilden. Bei dieser Ausführungsform wird somit bei jeder linksseitigen und rechtsseitigen Druckbeaufschlagung eine im Wesentlichen identische elektrische Charakteristik bezüglich Spannung und Stromstärke erzeugt.

Die Fig. 6, 6a, 6b zeigen eine weitere verbesserte Ausführungsform der Fig. 5. Bei dieser Ausführungsform sind zwischen den Elektretfolien 2, 22 jeweils mittig Abstandshalter 14 angeordnet. Die Abstandshalter 14 dienen, wie in der Fig. 4a, 4b beschrieben, dazu, leichter in die entspannten Zustände nach einer Druckkrafteinwirkung auf die Solldruckfläche 81 bzw. 82 zurückzufinden. Der Ausgleichsraum 20 ist einmal in der Fig. 6a, rechtsseitig angeordnet und wandert in der Darstellung der Fig. 6b auf die linke Seite der als Doppeltasche ausgebildeten Hülle 10.

Die Fig. 7 zeigt schematisch im Querschnitt gesehen einen erfindungsgemäßen Taster 23 mit einem Tasterelement 25, einem Gehäuse 24 und einem erfindungsgemäßen vorher beschriebenen elektrostatischen Mikrogenerator 1. Bei Betätigung des Tasterelements 25 als zentrale Tastdruckfläche wird eine Druckkraft auf die Solldruckfläche 8 des elektrostatischen Mikrogenerators 1 ausgeübt, so dass eine elektrische Energie und Spannung erzeugt wird. Die rechtsseitig angeordnete Feder 9 führt den Mikrogenerator wieder in einen entspannten Zustand, so dass der Taster 23 erneut betätigt werden kann. Der elektrostatische Mikrogenerator 1 ist an eine Signalsteuerung 26 gekoppelt, die bei Betätigung des Tasterelements 25 die gewandelte elektrische Energie als elektrisches Signal weitergibt, beispielsweise an ein Funkmodul, so dass das Signal des Tasters 23 in einer gesamten elektrischen Anwendung verarbeitet wird.

Die Fig. 8 zeigt die zwei Verfahrensschritte zur Herstellung eines erfindungsgemäßen elektrostatischen Mikrogenerators 1. In einem ersten Verfahrensschritt S1 wird eine polymere Elektretfolie 2, 22 mit einer angeordneten metallischen Schicht doppellagig, flächig und locker gewickelt und in einem zweiten Schritt S2 wird die gewickelte Elektretfolie 2, 22 in einer Hülle 10 mit einem definierten Fluidvolumen hermetisch dicht verschlossen.

Die Fig. 9 zeigt die zwei Verfahrensschritte zur Erzeugung elektrischer Energie mittels eines elektrostatischen Mikrogenerators 1, wie er oben beschrieben wurde. Ein Fluid, hier besonders bevorzugt Luft, wird in einem ersten Schritt als Isolationsmedium parallel zu Kondensatorplatten 3, 4, die als metallische Schichten auf jeweils einer Elektretfolie 2, 22 angeordnet sind, und senkrecht zu einer Druckbeaufschlagung auf die Solldruckfläche 8, aus Fluidkammern 5, 6 in einen Ausgleichsraum 20, insbesondere einem Vorratsraum der Hülle 10 Schritt S10 herausgedrückt und umgekehrt wird das

Fluid aus dem Ausgleichsraum 20 von der Hülle im Schritt S20 zwischen die Kondensatorplatten 3, 4 parallel zur Aufweitung des Abstandes zwischen diesen wieder in die Fluidkammern 5,6 eingeführt und somit zurückgeführt.

Durch das parallele Einführen von Fluid und umgekehrt dem Herauspressen wird somit ein sehr hoher Wirkungsgrad bei einem stabilen Umwandlungsverfahren von mechanischer in elektrische Energie geschaffen. Es ist somit der elektrostatische Mikrogenerator deutlich einfacher und somit kostenreduzierter herstellbar, wobei auch eine breite Materialauswahl möglich ist. Jedes bekannte Elektretmaterial wie zum Beispiel Polytetrafluorethylen (PTFE), Polyethylenterephthalat (PET), Polyvinylchlorid (PVC) etc. oder insbesondere

Polyvinylidenfluorid (PVDF) kann als Folie verwendet werden.

Obwohl in der vorliegenden Beschreibung exemplarische Ausführungen erläutert wurden, sei darauf hingewiesen, dass eine Vielzahl von Abwandlungen möglich ist. Außerdem sei darauf hingewiesen, dass es sich bei den exemplarischen Ausführungen lediglich um Beispiele handelt, die den Schutzbereich, die Anwendung und den Aufbau in keiner Weise einschränken sollen. Vielmehr wird dem Fachmann durch die vorausgehende Beschreibung ein Leitfaden für die Umsetzung von mindestens einer exemplarischen Ausführung gegeben, wobei diverse Änderungen, insbesondere im Hinblick auf die Funktion und Anordnung den beschriebenen Bestandteile, vorgenommen werden können, ohne den Schutzbereich zu verlassen, wie es sich aus den Ansprüchen und diesen äquivalenten Merkmalskombinationen ergibt.

## Patentansprüche

1. Elektrostatischer Mikrogenerator (1) mit zwei polymeren, doppellagig übereinander angeordneten Elektretfolien (2, 22) mit jeweils einer einseitig darauf angeordneten metallischen Schicht als Elektrode, wobei die metallischen Schichten jeweils Kondensatorplatten (3, 4) ausbilden und mindestens eine in der Höhe veränderbare Fluidkammer (5, 6) zwischen den Kondensatorplatten (3, 4) ausgebildet ist und ein Fluid in der mindestens einen Fluidkammer (5, 6) als Isolationsmedium dient, die Elektretfolien (2, 22) flächig, locker gewickelt in einer für das Fluid der hermetisch abgedichteten Hülle (10) mit einem definierten Volumen des Fluids angeordnet sind, wobei in der Hülle (10) ein Ausgleichsraum (20) für das Fluid vorgesehen ist, wobei mittels Druckbeaufschlagung auf eine erste Solldruckfläche (8), die parallel zu den Kondensatorplatten (3, 4) auf der Hülle (10) außenliegend vorgesehen ist, das Fluid aus der mindestens einen Fluidkammer (5, 6) in Ausgleichsraum (20) der Hülle (10) herausdrückbar ist und so eine Spannung durch eine Veränderung des Abstands der Kondensatorplatten (3, 4) erzeugbar ist und unter Druckbeaufschlagung auf eine zweite Solldruckfläche (7) das Fluid im Wesentlichen in senkrechter Richtung zur Richtung der Druckbeaufschlagung aus dem Ausgleichsraum (20) der Hülle (10) in paralleler Richtung zur Anordnung der Kondensatorplatten (3, 4) in die Fluidkammer (5, 6) zur Aufweitung des Abstandes zwischen diesen parallel zu den Kondensatorplatten (3, 4) wieder einführbar und zurückführbar ist.

2. Elektrostatischer Mikrogenerator (1) nach Anspruch 1, **dadurch gekennzeichnet, dass** im Querschnitt gesehen die Elektretfolien (2, 22) zu mehreren Folienkondensatoren in Serie mit einem veränderbaren Abstand der Kondensatorplatten (3, 4) zu einem Folienwickel flächig gewickelt sind, wobei jeweils Seiten der Elektretfolie (2, 22) gleicher Polarität zueinander angeordnet sind und die Kondensatorplatten (3, 4) als Elektroden gleicher Polarität zusammen zu einer Leitung (30, 40) verschaltet sind.

3. Elektrostatischer Mikrogenerator (1) nach einem der Ansprüche 1 oder 2, **dadurch gekennzeichnet, dass** die metallische Schicht (3, 4) und insbesondere die Elektretfolie (2, 22) im Wesentlichen undurchlässig für das Fluid, insbesondere Luft, ausgebildet ist.

4. Elektrostatischer Mikrogenerator (1) nach Anspruch 1, 2 oder 3, **dadurch gekennzeichnet, dass** die metallische Schicht (3, 4) als separate Metallfolie auf der polymeren Elektretfolie (2, 22) angeordnet ist oder insbesondere die metallische Schicht (3, 4) auf der polymeren Elektretfolie (2, 22) als Metallisierung ausgebildet ist.

5. Elektrostatischer Mikrogenerator (1) nach einem der Ansprüche 1 bis 4, **dadurch gekennzeichnet, dass** die Elektretfolie (2, 22) die metallische Schicht (3, 4) auf einer Oberseite vollständig überdeckend aufweist.

6. Elektrostatischer Mikrogenerator (1) nach einem der Ansprüche 1 bis 5, **dadurch gekennzeichnet, dass** die Elektretfolie (2, 22) die metallische Schicht (3, 4) im Wesentlichen mittig auf einer Oberseite mit parallelen freien Randstreifen ohne metallische Schicht (3, 4) aufweist, wobei elastische Abstandshalter (11, 14) jeweils zwischen zwei Lagen der Elektretfolie (2, 22) jeweils an den zwei freien Randstreifen ohne metallische Schicht (3, 4) angeordnet sind.

7. Elektrostatischer Mikrogenerator (1) nach einem der Ansprüche 1 bis 5, **dadurch gekennzeichnet, dass** die metallische Schicht (3, 4) auf der Elektretfolie (2, 22) einseitig auf parallelen Randstreifen mit einem freien mittigen Streifen ohne metallische Schicht (3, 4) ausgebildet ist.

8. Elektrostatischer Mikrogenerator (1) nach Anspruch 7, **dadurch gekennzeichnet, dass** elastische Abstandshalter (11, 14) mittig zwischen zwei Lagen der Elektretfolie (2, 22) auf einem freien mittigen Streifen ohne metallischer Schicht (3, 4) angeordnet sind.

9. Elektrostatischer Mikrogenerator (1) nach einem der Ansprüche 1 bis 8, **dadurch gekennzeichnet, dass** die doppellagig angeordneten Elektretfolien (2, 22) auf einer Seite in der Hülle (10) angeordnet sind und der mindestens eine Ausgleichsraum (20) auf einer gegenüberliegenden Seite in der Hülle (10) angeordnet ist.

10. Elektrostatischer Mikrogenerator (1) nach einem der Ansprüche 1 bis 8, **dadurch gekennzeichnet, dass** die doppellagig angeordneten Elektretfolien (2, 22) mit ihren Fluidkammern (51, 52, 61, 62) als wechselseitiger Ausgleichsraum (20) jeweils über der ersten und zweiten Solldruckfläche (8, 7) ausgebildet sind.

11. Elektrostatischer Mikrogenerator (1) nach Anspruch 8, **dadurch gekennzeichnet, dass** die erste und die zweite Solldruckfläche (81, 82) auf der Oberseite der Hülle (10) angeordnet sind, wobei die Solldruckflächen (81, 82) abwechselnd betätigbar sind, insbesondere eine Mechanik vorgesehen ist, die abwechselnd beide Solldruckflächen (81, 82) mit einer Druckkraft beaufschlagt, ausgehend von der Beaufschlagung einer definierten zentralen Tastdruckfläche.

12. Elektrostatischer Mikrogenerator (1) nach einem der Ansprüche 1 bis 9, **dadurch gekennzeichnet, dass** der elektrostatische Mikrogenerator (1) eine Federmechanik aufweist, die einem Zusammendrücken auf die mindestens eine Solldruckfläche (8) entgegenwirkt und zur elektrischen Energieerzeugung angenäherte Kondensatorplatten (3, 4) wieder aufweitet.

13. Taster (23) mit einem elektrostatischen Mikrogenerator (1), nach einem der Ansprüche 9 oder 10, einem gefedert gelagerten Tasterelements (25) und einer Signalsteuerung (26) zur Abgabe eines elektronischen Signals bei Betätigung des Tasterelements (25) mit Auslösung einer Druckbeaufschlagung auf die Solldruckfläche (8) des Mikrogenerators.

14. Verfahren zur Herstellung eines elektrostatischen Mikrogenerators (1) nach einem der Ansprüche 1 bis 10 mit polymerer Elektretfolie (2, 22), wobei die Elektretfolie (2, 22) derart gewickelt wird, so dass ein Fluid im Wesentlichen senkrecht zur Richtung der Druckbeaufschlagung auf eine Solldruckfläche des Mikrogenerators zwischen Lagen der Elektretfolie (2, 22) und Elektroden als Kondensatorplatten (3, 4) parallel zu diesen heraus- und hineinströmbar ist und die gewickelte Elektretfolie (2, 22) in einer Hülle (10) mit einem definierten Fluidvolumen hermetisch dicht verschlossen wird.

15. Verfahren zur Erzeugung von elektrischer Energie mittels eines elektrostatischen Mikrogenerators (1) nach einem der Ansprüche 1 bis 10, wobei ein Fluid, insbesondere Luft, als Isolationsmedium parallel zu Kondensatorplatten (3, 4) und senkrecht zu einer Druckbeaufschlagung auf eine Solldruckfläche (8) in einen Ausgleichsraum (20) einer Hülle (10) herausgedrückt wird und danach umgekehrt das Fluid aus dem Ausgleichsraum (20) der Hülle (10) zwischen Kondensatorplatten (3, 4) zur Aufweitung des Abstandes zwischen diesen parallel zu den Kondensatorplatten (3, 4) eingeführt und zurückgeführt wird.

## Claims

1. Electrostatic microgenerator (1) with two polymer, double layer electret films (2, 22) arranged on top of one another, both with a one sided metallic layer arranged on top of them as an electrode, whereby the metallic layers both form capacitor plates (3, 4) and at least one fluid chamber (5, 6), the height of which can be adjusted, is formed between the capacitor plates (3, 4) and a fluid serves as insulator material in the at least one fluid chamber (5, 6),
the electret films (2, 22) are arranged flat, loosely wound in a case (10) that is hermetically sealed for the fluid with a defined volume of the fluid, whereby an equalising chamber (20) for the fluid is included in the case (10),
whereby by applying pressure on a first target pressure surface (8), which is included parallel to the capacitor plates (3, 4) on the outside of the case (10), the fluid can be pushed out of the at least one fluid chamber (5, 6) into the equalising chamber (20) of the case (10) and thus a voltage can be generated by a changing of the distance between the capacitor plates (3, 4) and under the application of pressure on a second target pressure surface (7) the fluid can be introduced and returned essentially perpendicular to the direction of the pressure applied from the equalising chamber (20) of the case (10) in a parallel direction to the arrangement of the capacitor plates (3, 4) into the fluid chamber (5, 6) to increase the distance between these, parallel to the capacitor plates (3, 4).

2. Electrostatic microgenerator (1) according to claim 1, **characterised in that,** viewed in cross-section, the electret films (2, 22) in several film capacitors in a row with an adjustable distance between the capacitor plates (3, 4) are wound, flat into a film roll, whereby sides of the electret films (2, 22) with the same polarity are respectively arranged with each other and the capacitor plates (3, 4) are connected, as electrodes with the same polarity, together to a conductor (30, 40).

3. Electrostatic microgenerator (1) according to one of the claims 1 or 2, **characterised in that,** the metallic layer (3, 4) and in particular the electret film (2, 22) is formed essentially impermeable for the fluid, in particular air.

4. Electrostatic microgenerator (1) according to claim 1, 2 or 3, **characterised in that** the metallic layer (3, 4) is arranged as a separate metal foil on the polymer electret film (2, 22) or in particular the metallic layer (3, 4) is formed on the polymer electret film (2, 22) as metallisation.

5. Electrostatic microgenerator (1) according to one of the claims 1 to 4, **characterised in that** the electret film (2, 22) fully covers the metallic layer (3, 4) on one upper side.

6. Electrostatic microgenerator (1) according to one of the claims 1 to 5, **characterised in that** the electret film (2, 22) has the metal layer (3, 4) essentially in the centre of one upper side with parallel free edge strips with no metallic layer (3, 4) whereby flexible spacers (11, 14) are arranged respectively between two layers of the electret film (2, 22) and respectively on the two free edge strips with no metallic layer (3, 4).

7. Electrostatic microgenerator (1) according to one of the claims 1 to 5, **characterised in that** the metallic layer (3, 4) is formed on the electret film (2, 22) on one side on parallel edge strips with a free centre strip with no metallic layer (3, 4).

8. Electrostatic microgenerator (1) according to claim 7, **characterised in that** flexible spacers (11, 14) are arranged in the centre between two layers of the electret film (2, 22) on a free centre strip with no metallic layer (3, 4).

9. Electrostatic microgenerator (1) according to one of the claims 1 to 8, **characterised in that** the electret films (2, 22) arranged in a double layer, are arranged on one side of the case (10) and the at least one equalising chamber (20) is arranged on an opposite side in the case (10).

10. Electrostatic microgenerator (1) according to one of the claims 1 to 8, **characterised in that** the electret films (2, 22) arranged in a double layer with their fluid chambers (51, 52, 61, 62) are formed as an alternating equalising chamber (20) above the first and second target pressure surface (8, 7) respectively.

11. Electrostatic microgenerator (1) according to claim 8, **characterised in that** the first and second target pressure surfaces (81, 82) are arranged on the upper side of the case (10), whereby the target pressure surfaces (81, 82) can operate alternately, in particular a mechanism is included that alternately applies pressure to both target pressure surfaces (81, 82), originating from the application of a defined central tactile pressure surface.

12. Electrostatic microgenerator (1) according to the claims 1 to 9, **characterised in that** the electrostatic microgenerator (1) has a spring mechanism that counteracts compression on the at least one target pressure surface (8) and expands capacitor plates (3, 4) which have become close again to generate electrical energy.

13. Button (23) with an electrostatic microgenerator (1) according to one of the claims 9 or 10, a spring-loaded, mounted button element (25) and a signal control (26) for sending an electronic signal when the button element (25) is operated with activation of an application of pressure to the target pressure surface (8) of the microgenerator.

14. Method of production of an electrostatic microgenerator (1) according to one of the claims 1 to 10 with polymer electret film (2, 22), whereby the electret film (2, 22) is wound such that a fluid can flow in and out between layers of the electret film (2, 22) and electrodes as capacitor plates (3, 4) parallel to these, essentially perpendicular to the direction of the pressure applied to a target pressure surface of the microgenerator, and the wound electret film (2, 22) is hermetically sealed in a case (10), with a defined volume of the fluid.

15. Method of generation of electrical energy using an electrostatic microgenerator (1) according to one of the claims 1 to 10, whereby a fluid, in particular air, as an insulator material, is pressed out parallel to capacitor plates (3, 4) and perpendicular to an application of pressure on a target pressure surface (8) into an equalising chamber (20) of a case (10) and afterwards, conversely, the fluid from the equalising chamber (20) of the case (10) is entered and returned between capacitor plates (3, 4) to extend the distance between these, parallel to the capacitor plates (3, 4).

## Revendications

1. Micro-générateur électrostatique (1) avec deux feuilles d'électret (2, 22) disposées en double couche superposée de deux polymères, chacune avec une couche métallique disposée sur l'une des faces comme électrode, les couches métalliques formant respectivement des plaques de condensateur (3, 4) et au moins une chambre de fluides à hauteur variable (5, 6) étant formée entre les plaques du condensateur (3,4) et un fluide servant de milieu isolant dans l'une au moins des chambres de fluide (5, 6), les feuilles d'électret (2, 22) étant disposées à plat, lâchement enroulées dans une enveloppe hermétique (10) pour le fluide, dans laquelle une chambre de compensation (20) est prévue pour le fluide dans l'enveloppe (10), dans laquelle, au moyen d'une pressurisation sur une première surface de pression de consigne (8) prévue parallèlement aux plaques de condensateur (3, 4) sur l'enveloppe (10) à l'extérieur, le fluide provenant de la au moins une chambre de fluide (5, 6) étant expulsable dans la chambre de compensation (20) de l'enveloppe (10), une tension étant ainsi générable par un changement de l'espacement des plaques de condensateur (3, 4) et le fluide étant sensiblement réinsérable et traçable, sous pression à une deuxième surface de pression de consigne (7), dans une direction perpendiculaire à la direction de la pression de la chambre de compensation (20) de l'enveloppe (10) dans une direction parallèle à l'agencement des plaques de condensateur (3, 4) dans la chambre de fluide (5, 6) pour dilater la distance entre celles parallèles aux plaques de condensateur (3, 4).

2. Micro-générateur électrostatique (1) selon la revendication 1, **caractérisé en ce que,** vu en coupe transversale, les feuilles d'électret (2, 22) sont enroulées à plat pour former une pluralité de condensateurs de film en série avec une distance variable entre les plaques de condensateur (3, 4) et un enroulement de feuille, chacune des faces de la feuille d'électret (2, 22) de même polarité étant disposée l'une sur l'autre et les plaques de condensateur (3, 4) étant interconnectées à une ligne sous forme d'électrodes de même polarité (30, 40).

3. Micro-générateur électrostatique (1) selon l'une des revendications 1 ou 2, **caractérisé en ce que** la couche métallique (3, 4) et notamment la feuille d'électret (2, 22) est essentiellement conçue de manière imperméable au fluide, notamment à l'air.

4. Micro-générateur électrostatique (1) selon la revendication 1, 2 ou 3, **caractérisé en ce que** la couche métallique (3, 4) est agencée sous la forme d'une feuille métallique séparée sur la feuille d'électret polymère (2, 22) ou, en particulier, la couche métallique (3,4) est agencée sur la feuille d'électret polymère (2, 22) comme métallisation.

5. Micro-générateur électrostatique (1) selon l'un des revendications 1 à 4, **caractérisé en ce que** la feuille d'électret (2, 22) chevauche complètement la couche métallique (3, 4).

6. Micro-générateur électrostatique (1) selon l'une des revendications 1 à 5, **caractérisé en ce que** la feuille d'électret (2, 22) présente la couche métallique (3, 4) sensiblement au centre d'un côté supérieur avec des bandes de bord libres parallèles sans couche métallique (3, 4), les espaceurs élastiques (11, 14) étant respectivement disposés sans couche métallique (3, 4) entre deux couches de la feuille d'électret (2, 22) sur chacune des deux bandes de bord libres.

7. Micro-générateur électrostatique (1) selon l'une quelconque des revendications 1 à 5, **caractérisé en ce que** la couche métallique (3, 4) sur la feuille d'électret (2, 22) est conçue d'un côté sur des bandes de bord parallèles avec une bande centrale libre sans couche métallique (3, 4).

8. Micro-générateur électrostatique (1) selon la revendication 7, **caractérisé en ce que** les espaceurs élastiques (11, 14) sont disposés au centre entre deux couches de feuille d'électret (2, 22) sur une bande centrale libre sans couche métallique (3, 4).

9. Micro-générateur électrostatique (1) selon l'une quelconque des revendications 1 à 8, **caractérisé en ce que** les feuilles d'électret sont disposées en double couche (2, 22) sur un côté de l'enveloppe (10) et **en ce que** au moins un espace de compensation (20) est disposé sur un côté opposé de l'enveloppe (10).

10. Micro-générateur électrostatique (1) selon l'une quelconque des revendications 1 à 8 **caractérisé en ce que** les feuilles d'électret disposées en double couche (2, 22) sont conçues avec leurs chambres de fluide (51, 52, 61, 62) comme espace de compensation (20), chacune sur les première et deuxième surfaces de pression de consigne (8, 7).

11. Micro-générateur électrostatique (1) selon la revendication 8, **caractérisé en ce que** la première et la deuxième surface de pression de consigne (81, 82) sont disposées sur la face supérieure de l'enveloppe (10), les surfaces de pression de consigne (81, 82) étant alternativement actionnables,
**en ce qu'**il est prévu un mécanisme agissant alternativement avec une force de pression sur les deux surfaces de pression de consigne (81, 82), en commençant par l'application d'une surface de pression tactile centrale définie.

12. Micro-générateur électrostatique (1) selon l'une quelconque des revendications 1 à 9, **caractérisé en ce que** le micro-générateur électrostatique (1) présente un mécanisme à ressort qui neutralise une compression sur l'au moins une surface de pression de consigne (8) et élargit à nouveau les plaques de condensateur (3, 4) approximé à la production d'énergie électrique.

13. Bouton-poussoir (23) avec un micro-générateur électrostatique (1), selon l'une quelconque des revendications 9 à 10, un élément de bouton-poussoir monté sur ressort (25) et un contrôleur de signal (26) visant à émettre un signal électronique lors de l'actionnement de l'élément de bouton-poussoir (25) avec déclenchement d'une pressurisation sur la surface de pression de consigne (8) du micro-générateur.

14. Procédé de fabrication d'énergie électrique au moyen d'un micro-générateur 14 Procédé de fabrication d'un micro-générateur électrostatique (1) selon l'une quelconque des revendications 1 à 10 avec feuille d'électret polymère (2,22), dans lequel la feuille d'électret (2,22) est enroulée de sorte qu'un fluide sensiblement perpendiculaire à la direction de pressurisation d'une surface de pression de consigne du micro-générateur peut s'écouler vers l'intérieur ou l'extérieur parallèlement à celui-ci, entre les couches de feuille d'électret (2, 22) et les électrodes sous forme de plaques de condensateur (3, 4) et les feuilles d'électret enroulées (2, 22) sont enfermées hermétiquement dans une enveloppe (10) avec un volume de fluide défini.

15. Procédé de fabrication d'énergie électrique au moyen d'un micro-générateu électrostatique (1) selon l'une quelconque des revendications 1 à 10, dans lequel un fluide, notamment de l'air, est expulsé sous forme de milieu isolant parallèle aux plaques de condensateur (3, 4) et perpendiculaire à une mise en pression sur une surface de pression de consigne (8) dans un espace de compensation (20) d'une enveloppe (10), puis , à l'inverse, le fluide est introduit et renvoyé de l'espace d'expansion (20) de l'enveloppe (10) entre les plaques de condensateur (3, 4) pour élargir la distance entre celles parallèles aux plaques de condensateur (3, 4).
